# EUROPÄISCHE PATENTSCHRIFT

(11) **EP 0 700 409 B1**
(45) Veröffentlichungstag und Bekanntmachung des Hinweises auf die Patenterteilung: **02.08.2000**
(21) Anmeldenummer: 94918334.7
(22) Anmeldetag: 17.05.1994
(51) Int. Cl.: C08G 18/40, C09J 5/06

(54) **THERMISCH VERNETZBARER HEISSIEGEL-KLEBSTOFF**
THERMALLY CROSS-LINKABLE HEAT-SEALING ADHESIVE
ADHESIF THERMOSOUDABLE THERMIQUEMENT RETICULABLE

(30) Priorität: 26.05.1993 DE 4317470
(43) Veröffentlichungstag der Anmeldung: 13.03.1996
(73) Patentinhaber: Henkel Kommanditgesellschaft auf Aktien, 40191 Düsseldorf (DE)
(72) Erfinder: BOLTE, Gerd, D-40789 Monheim (DE); HENKE, Günter, D-41470 Neuss (DE); BRÜNINGHAUS, Ulrike, D-40699 Erkrath (DE)
(86) Internationale Anmeldenummer: EP9401598
(87) Internationale Veröffentlichungsnummer: WO9428046

(56) Entgegenhaltungen:
- EP-A- 0 074 218
- EP-A- 0 519 177
- FR-A- 2 305 481
- GB-A- 2 030 991

## Beschreibung

Die Erfindung betrifft einen thermisch vernetzbaren Heißsiegel-Klebstoff auf der Basis von Polyurethan sowie dessen Anwendung bei Elektroartikeln.

Unter einem Heißsiegel-Klebstoff ist ein wärmeaktivierbarer Klebstoff zu verstehen, der auf ein oder beide zu verbindende Substrate aufgebracht wird und dort einen Film bildet. Beim Erwärmen und Zusammenpressen wird der Klebstoff aktiviert, so daß nach dem Abkühlen beide Teile miteinander verbunden sind. Als Basis für derartige Heißsiegel-Klebstoffe eignen sich unter anderem Polymere aus Ethylen, Vinylchlorid, Vinylidenchlorid, Vinylacetat und (Meth)acrylaten sowie Polyamide, Polyester und Polyurethane. Wenn man temperaturbeständige Verklebungen erzielen möchte, nimmt man anstelle von thermoplastischen Polymeren - wie Polyester, Polyamid und Polyolefin - Systeme, die bei der Erwärmung in der Regel auf 150 bis 250 °C zu Duroplasten vernetzen, wie z.B. Polyurethane, Copolymethacrylate, Epoxidharze und Phenolharze. Die Heißsiegel-Klebstoffe werden durch Tauchen, Tränken, Sprühen oder mit Hilfe von Walzen und Sieben auf das Substrat aufgetragen. Als Substrat kommen vor allem bahnförmige Materialien aus Metall und Kunststoff in Form von Folien, Textilien und Papieren in Frage. Auf diese Weise können zwei oder mehr Lagen gleicher oder verschiedener Art in der Regel durch Kalandrieren leicht miteinander verbunden (kaschiert) werden.

Ein derartiger thermisch vernetztbarer Heißsiegel-Klebstoff auf Basis von Polyurethan wird in der DE-A-25 13 378 beschrieben. Er besteht aus einem Polyurethan bzw. Polyisocyanaten, aus einem Lösungsmittel und aus einem Addukt, hergestellt aus einer mehrfunktionellen Epoxidverbindung und Novolak (siehe Anspruch 1). Die Epoxidharze basieren beispielsweise auf Diphenylolpropan oder epoxidierten cycloaliphatischen Dienen. Es können aber auch Diazinepoxidharze sein. Bevorzugt werden Addukte von kristallisiertem Triglycidylisocyanurat an Novolak im Gewichtsverhältnis 30 : 70 bis 60 : 40, wobei der Epoxidgehalt 3 bis 6 % betragen sollte. Die Verklebung erfordert nur einen geringen Druck von 1 bis 10, insbesondere 2 bis 5 kp/cm² bei Temperaturen zwischen etwa 120 und 180 °C, während etwa 2 bis 30 min. So hergestellte Kupfer/Polyimid-Laminate zeigen eine Lötbadbeständigkeit von wenigstens 10 sek bei 260 °C. An Stahlblechen wurden Zugfestigkeiten von 80 bzw. 120 kg/cm² und Schälfestigkeiten von 11 bzw. 20 kg/cm² gemessen.
Dieser bekannte Klebstoff genügt nicht mehr allen heutigen Anforderungen: Durch neue Technologien in der Leiterplattenherstellung (Oberflächenmontage von Bauteilen, Starr-Flex-Schaltungen, Umschmelzvorgänge) sind Kurzzeittemperaturbeständigkeiten von 350 °C erforderlich. Außerdem verlangen neue Anwendungsgebiete von Laminaten für Außenanwendungen eine verbesserte Hydrolyse-Beständigkeit bei guter Haftung auf kritischen Materialien (z.B. fluorhaltige Polymere).
Daraus ergibt sich die Aufgabe, Heißsiegelklebstoffe bereitzustellen, deren Film je nach der Anforderung und Einstellung klebrig oder blockfest ist und die eine hohe Temperaturbeständigkeit und gute Hydrolysestabilität besitzen. Allgemeiner ausgedrückt:
Der Klebstoff sollte einfach herzustellen und universeller anzuwenden sein sowie bessere Gebrauchseigenschaften zeigen.

Die erfindungsgemäße Lösung ist den Patentansprüchen zu entnehmen. Sie besteht in einem thermisch vernetzbaren Heißsiegel-Klebstoff aus einem Gemisch aus einem Polyacrylat einerseits und einem Epoxid-Harz/-Novolak-Addukt andererseits (Komponente A) als Reaktionskomponente für ein Polyisocyanat (Komponente B) oder ein Polyol (Komponente C) aus einem OH-terminierten Polyurethan oder Polyester. Das Addukt besteht aus einem Epoxidharz auf der Basis von Bisphenol-A, heterocyclischen oder aliphatischen Epoxid-Verbindungen und aus Novolak oder Bisphenol-A-Novolak.

Die Komponente A enthält ein vernetzendes Addukt auf der Basis von Novolak und Epoxidharz, das mit einem Acrylesterpolymer versetzt wird.

Unter "Novolak" sind Säure-katalysierte Polykondensationsprodukte aus Aldehyden und Phenolen zu verstehen, die keine Methylol-Gruppe enthalten. Als Phenole kosten in Frage: Alkyl-Phenole wie Kresol-, Xylenol-, Nonyl- und Octyl-Phenol oder Aryl-Phenole wie Phenylphenol oder zweiwertige Phenole wie Resorcin und Bisphenol-A sowie Naphthenole. Bevorzugte Phenole sind Bisphenol-A und Phenol. Als Aldehyde kommen in Frage: Formaldehyd. Handelsübliche Novolake sind: Alnovol, Durez, Schenetady, Bakelite.

Unter "Epoxidharz" sind oligomere Verbindungen mit mehr als einer Epoxid-Gruppe pro Molekül zu verstehen. Die erfindungsgemäßen Epoxid-Harze werden durch Reaktion von Epoxiden wie Epichlorhydrin mit Bisphenol-A (2,2-Bis-(hydroxyphenyl)-propan) mit aliphatischen, einschließlich cycloaliphatischen Verbindungen wie Cyclohexandiol oder mit heterocyclischen Verbindungen wie Trihydroxyethyl(isocyanurat) hergestellt. Beispiele für derartige Epoxid-Harze sind: Rütapox, Epikote, Eurepox, Araldit-Typen.

Sie können auf bekannte Art und Weise hergestellt werden.

Zur Bildung der Addukte werden die Novolake und die Epoxid-Harze im Gewichtsverhältnis von 10 : 90 bis 90 : 10, vorzugsweise von 30 : 70 bis 70 : 30 zu 1 gemischt und auf 70 bis 180 °C, vorzugsweise bis 120 °C erwärmt. Der Epoxid-Gehalt beträgt 0,5 bis 50 %, vorzugsweise 1 bis 5 %. Der OH-Gehalt beträgt 1 bis 40, vorzugsweise 2 bis 20 % OH.

Als geeignete Acrylester-Polymere im Sinne der Erfindung seien beispielsweise (Meth)acryl-Styrol-Acrylnitril-Copolymere oder Polybutylmethacrylat genannt. Geeignet sind auch die Homopolymeren oder Copolymeren der Acrylsäure sowie der Methacrylsäure. Besonders bevorzugt werden vorstehend beschriebene Polymere, wenn sie ein mittleres Molekulargewicht von 50 000 bis 300 000 aufweisen. Im Sinne der Erfindung bevorzugt sind solche Homo- oder Copolymeren, deren Summe von Säurezahl und OH-Zahl im Bereich von 1 bis 200 liegt. Besonders gute Ergebnisse weisen die genannten Polymeren auf, wenn diese Summe zwischen 30 und 150, insbesondere jedoch im Bereich von 50 bis 100 liegt.

Handelsübliche Typen sind Desmophen, Lumitol, Acronal u.ä.
Das Mischungsverhältnis mit dem Epoxidharz/Novolak-Addukt beträgt 0,1 : 100 bis 100 : 10, vorzugsweise 0,2 : 100 bis 60 : 40.

Bei den "Polyisocyanaten handelt es sich um Verbindungen mit 2 oder mehr, vorzugsweise 2 oder 3 freie oder verkappte Isocyanat-Gruppen. Bei den verkappten Isocyanaten ist die Isocyanatgruppe nach Temperatureinwirkung verfügbar.

Konkrete Beispiele sind: Desmodur, Basomat, Vestanat, Scuranate, Desmocap.

Unter "Polyurethan-Prepolymeren" sind oligomere Polyurethan-Verbindungen mit durchschnittlich 2 bis 10, inbesondere 2 bis 4 Urethan-Gruppen pro Molekül zu verstehen. Sie können auf bekannte Weise aus einem Polyol, insbesondere einem Diol und einem Polyisocyanat, insbesondere einem Diisocyanat hergestellt werden. Als Polyole kommen in Frage: Polyester, Polyether, Heterocyclen, Bisphenol-A-Polyole, aliphatische, aromatische Alkohole 1-n-funktional.
Davon sind bevorzugt Polyester und Polyether.
Als Polyisocyanate kommen in Frage: MDI, TDI, IPDI, HDI, TMXDI, Naphthyldiisocyanate usw..

Davon sind bevorzugt MDI, TDI, IPDI.
Das Verhältnis von Polyol : Polyisocyanat ist so zu wählen, daß Prepolymere mit 2 bis 6, vorzugsweise 2 bis 4 NCO-Gruppen pro Molekül Prepolymer entstehen.
Konkrete Beispiele für NCO-terminierte Polyurethan-Prepolymere sind: Liofol UK 3645, UR 3690, UR 3850, UR 7740, UR 7750.

Das Polyol aus einem OH-terminierten Polyurethanprepolymer oder Polyester hat eine OH-Zahl von 1 bis 200, vorzugsweise von 1 bis 70 und ein mittleres Molekulargewicht (Mn) von 500 bis 100 000, vorzugsweise von 1 000 bis 30 000.
Handelsübliche Typen sind: Liofol, Desmophen, Luphen, Dynacoll.

Je nach Anwendung und Funktionalität wird die Komponente A mit der Komponente B oder C im Gewichtsverhältnis 1 : 50 bis 50 : 1, vorzugsweise 1 : 20 bis 20 : 1 gemischt.

Neben diesen beiden wesentlichen Komponenten A) sowie B) oder C) kann der Heißsiegel-Klebstoff noch weitere Komponenten enthalten, die sich in Art und Menge nach der konkreten Anwendung richten. So werden z.B. Polyester, Polyether, Polyepoxid-Harze, NBR-Kautschuk zugesetzt, um Filmhärte und Beständigkeit zu beeinflussen. Weitere Zusatzstoffe sind z.B. Silane, Verlaufshilfsmittel, Entschäumer Flammschutzmittel, Stabilisatoren oder Beschleuniger.

Der erfindungsgemäße Heißsiegel-Klebstoff wird durch Mischen der Komponenten hergestellt, wobei lösungsmittelfrei aber auch unter Zusatz eines Lösungsmittels gearbeitet werden kann, wenn es im konkreten Fall zweckmäßig ist. Als Lösungsmittel kommen in Frage: Ketone wie Aceton, Methylethylketon, Isobutylmethylketon oder Ester wie Essigsäureethylester oder Essigsäurepropylester sowie Chlorkohlenwasserstoffe wie Methylenchlorid, 1,2-dichlorethan und

Trichlorethylen. Selbstverständlich kommen auch weitere inerte Lösungsmittel wie Kohlenwasserstoffe, z.B. Toluol oder Cyclohexan mitverwendet werden.

Die erfindungsgemäßen Klebstoffe können durch Tauchen, Tränken oder Sprühen aufgetragen werden sowie mit Hilfe von Walzen und Sieben. Es können aber auch zunächst Filme hergestellt werden, indem man die Mischungen auf Silikonpapier oder sonstige antiadhäsiv ausgerüstete Materialien aufträgt und nach dem Verdunsten des Lösungsmittels den Film abhebt. Auf diese Weise können einerseits Beschichtungen auf zu verklebende Materialien hergestellt werden sowie andererseits auch Klebstoff-Filme, die zweckmäßigerweise erst unmittelbar vor ihrer Anwendung von dem Träger gelöst werden.

Je nach Art der Mischung erhält man einen klebrigen oder blockfreien Klebstoffilm, der durch Temperatur und Druckeinwirkung aktiviert werden kann.

Bei Mischungen der Komponenten A und B findet bereits bei Herstellung des Filmes bzw. seiner Lagerung bei Raumtemperatur eine Vernetzung durch eine OH/NCO-Reaktion statt, die dann durch Aushärtung bei erhöhten Temperaturen vervollständigt wird, indem auch die Epoxidgruppen reagieren.

Die Vorteile der erfindungsgemäßen Zusammensetzung gegenüber der aus der DE 25 13 378 bekannten sind:
- die Möglichkeit, den Film blockfest einzustellen,
- eine erheblich bessere Temperaturstabilität,
- eine höhere Hydrolysebeständigkeit und
- je nach Substrat niedrigere Aktivierungs- und Aushärtetemperaturen.

Darüber hinaus hat der erfindungsgemäße Klebstoff auch mindestens ebenso gute Eigenschaften bezüglich Flexibilität und Haftung auf verschiedenen Substraten, und zwar auch ohne Lösungsmittel.

Aufgrund dieser Vorteile eignen sich die erfindungsgemäßen Heißsiegel-Klebstoffe nicht nur zur Beschichtung von
- Metallfolien, z.B. aus Kupfer, Aluminium und Konstanten,
- Kunststoff-Folien, z.B. aus Polyimid, Polyethylenterephthalat, Polyphenylsulfid, PES (Polyethersulfon), PEEK (Polyetheretherketon) und Fluorpolymeren (PTFE, PVF, PVDF),
- Geweben und Vliesen aus Fasern von Polyethylenterephthalat, Glas und aromatischen Polyamiden und
- Papieren, Preßspanplatten und Polyaramidpapier,
   sondern auch als Klebstoff und Isolator in der Elektro- und Elektronik-Industrie, z.B.
- zur Herstellung von Flachkabeln und Kabelummantelungen,
- zur Isolation von elektrischen Leitern und Bauteilen,
- als Klebefolien für Multilayer
- und als Basismaterial oder Abdeckfolie für gedruckte Schaltungen.

Die Erfindung soll nun anhand von einzelnen Beispielen näher beschrieben werden.

### I) Herstellung und Beschreibung der Ausgangsprodukte

1. a) Epoxid-Harz auf Novolak-Basis
   Verwendet wurden handelsübliche Epoxidharze auf Novolak-Basis, wie z. B. Araldit xPS 307.
1. b) Acrylestercopolymer
   Verwendet wurden handelsübliche Acrylesterco- oder - terpolymere wie Lumitol M 81 oder Desmophen A 450.
2. Herstellung des Adduktes
   a) Epoxid-Harz auf Bisphenol-A-Basis/Bisphenol-A-Novolak-Addukt Die Mischung eines Epoxidharzes mit einem Bisphenol-A-Novolak in Ethylacetat wurde am Rückfluß zur Addition erhitzt.
   b) Epoxid-Harz auf Bisphenol-A-Basis/Novolak-Addukt siehe 2.a)
3. Herstellung der NCO-terminierten Polyurethan-Prepolymere
   a) Polyesterurethan-Prepolymer
      Handelsübliche OH-terminierte Polyester wurden mit einem Diisocyant im Additionsverhältnis NCO : OH = 2 : 1 umgesetzt.
   b) Polyisocyanat
      Verwendet wurden handelsübliche mehrfunktionelle Polyisocyanate, wie Desmodur VK, L, N. E, Vestanat T 1890, Basonat A 270.
   c) OH-terminierte Polyester bzw. Polyurethanprepolymere
      Es wurden OH-terminierte Polyester, wie Durocol S, L oder Desmophen-Typen, direkt oder nach ihrer Umsetzung mit einem Diisocyanat (Additionsverhältnis OH - NCO = 2 : 1) eingesetzt.

### II) Herstellung und Anwendung des Klebstoffes

4.1 Eine Mischung aus 10 Gewichtsteilen des NCO-terminierten Polyesterurethanprepolymers 3a) mit einem Gemisch aus 4 Gewichtsteilen des Adduktes 2a) und 1 Gewichtsteil des Epoxidharzes auf Novolak-Basis (1a) und 0,02 Gewichtsteilen des Acrylesters (1b) wurde aus einer 40 %igen Lösung in Ethylacetat durch Aufrakeln auf eine 35 µm Cu-Folie aufgetragen. Nach Entfernen des Lösungsmittels durch Heißluft in ca. 2 min ergab sich ein geschlossener, blockfester Film von 20 µm Dicke.
4.2 Die Kaschierung dieser beschichteten Cu-Folie bei 170 °C in 0,5 h und einem Druck von 20 bar gegen eine Polyimid-Folie ergab einen Verbund von sehr guter Temperaturbeständigkeit (> 60 s/250 °C und > 5 s/288 °C im Lötbad) und Verbundhaftung (nur unter Zerstörung des Materials trennbar).
4.3 Die gemäß 4.1 beschichtete Cu-Folie wurde bei 120 °C in 10 min und mit einem Druck von 20 bar gegen eine PETP-Folie kaschiert. Der Verbund hatte eine gute Temperaturstabilität (> 30 s/230 °C im Lötbad) und eine hohe Festigkeit (nur unter Materialriß trennbar).
4.4 Der Auftrag des unter 4.1 beschriebenen Klebstoffsystems auf eine 23-µm-PETP-Folien ergab nach Entfernen des Lösungsmittels ebenfalls einen geschlossenen, blockfesten Film von ca. 12 µm Dicke. Die Kaschierung bei 90 °C in 10 min und einem Druck von 20 bar gegen Polyaramidpapier ergab einen Verbund, der direkt nach der Kaschierung Faserriß zeigte. Eine hohe Temperaturbeständigkeit der Verklebung ist ebenfalls gegeben (> 48 h bei 180 °C).
4.5 Eine Mischung aus 10 Gewichtsteilen des NCO-terminierten Polyesterurethanprepolymers 3a) mit einem Gemisch aus 4.6 Gewichtsteilen (GT) des Adduktes 2a) 0,4 GT des Epoxidharzes auf Novolak-Basis (1a) und 0,01 GT des Acrylestercopolymers (1b) wurde aus einer 40 %igen Lösung in Ethylacetat durch Aufrakeln auf eine 20 µm Aluminium-Folie aufgetragen. Nach Entfernen des Lösungsmittels durch Heißluft in ca. 2 min ergab sich ein geschlossener, klebriger Film von 10 µm Dicke.
4.6 Die Kaschierung dieser Aluminium-Folie bei 70 °C gegen eine Polyesterfolie ergab nach 1 Woche Vernetzung bei Raumtemperatur und 1 Stunde (h) Temperung bei 120 °C eine Verbundhaftung von 10 N/15 mm. Nach Belastung des Verbundes für 50 h bei 128 °C in Wasser betrug die Verbundhaftung noch 70 % des Ausgangswertes.
5.1 Eine Mischung aus 10 Gewichtsteilen des NCO-terminierten Polyurethanprepolymers 3b) mit einem Gemisch aus 4 Gewichtsteilen des Adduktes 2b) und 1 Gewichtsteil des Epoxidharzes auf Novolak-Basis (1) und 0,02 Gewichtsteile Acrylester Copolymer (1b) wurde aus einer 40 %igen Lösung in Ethylacetat auf eine 35 µm Cu-Folie aufgerakelt. Nach Entfernen des Lösungsmittels durch Heißluft in 2 min ergab sich ein geschlossener, blockfester Film von 20 µm Dicke.
5.2 Die Kaschierung dieser gemäß 5.1 beschichteten Cu-Folie bei 170 °C in 30 min und einem Druck von 20 bar gegen eine Polyimid-Folie ergab einen Verbund von sehr guter Temperaturbeständigkeit (> 60 s/260 °C und > 30 s/288 °C im Lötbad) und hoher Festigkeit (Trennung ohne Materialriß nicht möglich).
5.3 Die gemäß 5.1 beschichtete Cu-Folie wurde bei 120 °C in 10 min und bei einem Druck von 20 bar gegen eine PETP-Folie kaschiert. Der Verbund hatte eine gute Temperaturstabilität (60 s/230 °C im Lötbad) und hohe Festigkeit (nur unter Materialriß trennbar).
6.1 10 GT einer Mischung aus 8 GT des Adduktes (2b) mit 2 GT des Epoxidharzes auf Novolak-Basis (1a) und 5 GT des Acrylestercopolymers (1b) mit 3 GT eines Polyisocyanates (3b) wurde aus einer 40 %igen Lösung in Ethylacetat auf 35 µm Cu-Folie aufgerakelt. Nach Entfernen des Lösemittels durch Heißluft in ca. 2 min ergab sich ein geschlossener, blockfester Film von 20µm Dicke.
6.2 Die Kaschierung dieser beschichteten Cu-Folie bei 170 °C in 0,5 h und einem Druck von 20 bar gegen eine Polyimidfolie ergab einen Verbund von ausgezeichneter Temperaturbesktändigkeit (> 60 s bei 350 °C im Lötbad) und Verbundhaftung (nur unter Materialriß trennbar).
7.1 Eine Mischung aus 50 GT eines Polyesters 3c mit einem Gemisch aus 4 Gewichtsteilen des Adduktes 2a), 1 GT des Epoxidharzes auf Novolakbasis (1a) und 0,02 GT des Acrylestercopolymers (1b) wurde auf eine 25 µm PETP Cu-Folie aufgetragen. Nach Entfernen des Lösungsmittels durch Heißluft in ca. 2 min ergab sich ein geschlossener, blockfreier Film von 20 µm Dicke.
7.2 Die beschichtete PETP-Folie wurde mit der Schichtseite gegen eine Cu-Folie bei 130 °C für 1 s mit 4 bar Druck gesiegelt. Nach Temperung des entstehenden Verbundes für 1 h bei 130 °C ist dieser nur noch unter Materialriß trennbar und zeigt eine Kurzzeitbeständigkeit von > 10 s bei 230 °C im Lötbad.

### III Vergleichsversuche

Zum Vergleich wurde Beispiel 3 aus der DE-A-25 13 378 herangezogen.
8.1 Eine Kaschierung einer Cu- mit einer Polyimid-Folie ergab eine Lötbadbeständigkeit von 60 s bei 260 °C und 15 s bei 288 °C sowie eine Verbundhaftung von 16 N/15 mm.
8.2 Eine Kaschierung einer Al- gegen eine Polyester-Folie zeigte nach 50 h bei 128 °C in Wasser Delaminationen. Weder bei Versuch 8.1 noch bei 8.2 war der Klebstoffilm nach der Applikation blockfest.

### Der Vergleich zeigt:

- Die erfindungsgemäßen Klebstoffe können blockfest eingestellt werden und benötigen im Gegensatz zu den bekannten daher keine Abdeckfolien.
- Die Kurzzeittemperaturstabilität (Lötbad) ist erheblich höher.
- Eine bessere Hydrolysestabilität wurde erreicht.
- Die Verbundhaftwerte sind deutlich höher.

Die Eigenschaften der Filme wurden folgendermaßen bestimmt.
- Die Verbundhaftung wurde im Schälversuch (90 ° Abzugswinkel, 15 mm Prüfstreifen) bestimmt.
- Die Temperaturbeständigkeit wurde bestimmt, indem
   a) der Verbund für 48 h bei der zu prüfenden Temperatur im Trockenschrank gelagert wurde oder
   b) der Verbund in ein auf die entsprechende Temperatur geheiztes Blei/Zinn-Bad getaucht wurde.
- Die Blockfestigkeit wurde bestimmt, indem der Klebstoffilm nach dem Trocknen mit einem Substrat verpreßt wurde.
- Die Lagerungsmöglichkeit wurde bestimmt, indem die Eigenschaften des frischen Produktes mit einem gelagerten verglichen wurden.

## Patentansprüche

1. Thermisch vernetzbarer Heißsiegel-Klebstoff aus
A) einem Gemisch aus
a) einem Addukt aus
- einem Epoxid-Harz auf der Basis von Bisphenol-A, aliphatischen oder heterocyclischen Epoxid-Verbindungen und
- einem Novolak oder Bisphenol-A-Novolak mit
b) einem Acrylesterpolymeren und
B) einem Polyisocyanat oder
C) einem Polyol aus einem OH-terminierten PUR oder Polyester.

2. Heißsiegel-Klebstoff gemäß Anspruch 1, dadurch gekennzeichnet, daß das Polyisocyanat ein NCO-terminiertes Polyurethan-Prepolymer mit 2 bis 10 Urethan-Gruppen pro Molekül ist.

3. Heißsiegel-Klebstoff nach den Ansprüchen 1 oder 2, dadurch gekennzeichnet, daß das Gemisch A) bei Raumtemperatur flüssig ist.

4. Heißsiegel-Klebstoff gemäß einem der Ansprüche 1 bis 3, dadurch gekennzeichnet, daß das Epoxid-Harz eine lineare Molekül-Kette hat.

5. Heißsiegel-Klebstoff gemäß mindestens einem der Ansprüche 1 bis 4, gekennzeichnet durch die OH-Zahl des Polyols von 1 bis 200 und ein mittleres Molekulargewicht von 500 bis 100 000.

6. Heißsiegel-Klebstoff nach mindestens einem der Ansprüche 1 bis 5, gekennzeichnet durch Acrylesterpolymere
mit einer Summe von Säure- und OH-Zahl von 1 bis 200.

7. Heißsiegel-Klebstoff nach mindestens einem der Ansprüche 1 bis 6, gekennzeichnet durch das Gewichtsverhältnis des Acrylesterpolymeren zum Epoxidharz/Novolak-Addukt von 0,1 : 100 bis 100 : 10.

8. Heißsiegel-Klebstoff nach mindestens einem der Ansprüche 1 bis 7, gekennzeichnet durch das Gewichtsverhältnis der Komponenten A zu B bzw. C von 1 : 50 bis 50 : 1.

9. Verwendung der Heißsiegel-Klebstoffe nach mindestens einem der Ansprüche 1 bis 8 für Elektroartikel, insbesondere zur Isolation von elektrischen Leitungen und Bauteilen, zur Herstellung von Flachkabeln und Kabelummantelungen sowie als Basis-Material und Abdeckfolie für gedruckte Schaltungen.

## Claims

1. A thermally crosslinkable heat-sealing adhesive of
A) a mixture of
a) an adduct of
- an epoxy resin based on bisphenol A, aliphatic or heterocyclic epoxy compounds and
- a novolak or bisphenol A novolak with
b) an acrylic-ester polymer and
B) a polyisocyanate or
C) a polyol of an OH-terminated PUR or polyester.

2. A heat-sealing adhesive as claimed in claim 1, characterized in that the polyisocyanate is an NOC-terminated polyurethane prepolymer containing 2 to 10 urethane groups per molecule.

3. A heat-sealing adhesive as claimed in claim 1 or 2, characterized in that the mixture A) is liquid at room temperature.

4. A heat-sealing adhesive as claimed in any of claims 1 to 3, characterized in that the epoxy resin has a linear molecular chain.

5. A heat-sealing adhesive as claimed in any of claims 1 to 4, characterized by an OH value of the polyol of 1 to 200 and an average molecular weight of 500 to 100,000.

6. A heat-sealing adhesive as claimed in at least one of claims 1 to 5, characterized by acrylate polymers with a sum of acid and OH values of 1 to 200.

7. A heat-sealing adhesive as claimed in at least one of claims 1 to 6, characterized by a ratio by weight of the acrylic-ester polymer to the epoxy resin/novolak adduct of 0.1:100 to 100:10.

8. A heat-sealing adhesive as claimed in at least one of claims 1 to 7, characterized by a ratio by weight between components A and B or C of 1:50 to 50:1.

9. The use of the heat-sealing adhesives claimed in at least one of claims 1 to 8 for electrical articles, more particularly for the insulation of electrical circuits and components, for the production of flat cables and cable sheaths and as a base material and cover film for printed circuits.

## Revendications

1. Adhésif thermosoudable thermiquement réticulable à base de :
A) un mélange de
a) un produit d'addition à base
- d'une résine époxy à base de bisphénol-A, de composés époxydiques aliphatiques ou hétérocycliques, et
- d'une novolaque ou un bisphénol-novolaque, avec
b) un polymère d'ester d'acryle et
B) un polyisocyanate ou
C) un polyol à base de PUR terminé par un OH ou d'un polyester.

2. Adhésif thermosoudable conformément à la revendication 1,
caractérisé en ce que
le polyisocyanate est un prépolymère de polyuréthane terminé par un NCO ayant de 2 à 10 groupes uréthane par molécule.

3. Adhésif thermosoudable selon la revendication 1 ou 2,
caractérisé en ce que
le mélange A) est liquide à température ambiante.

4. Adhésif thermosoudable conformément à l'une des revendications 1 à 3,
caractérisé en ce que
la résine époxy a une chaîne de molécule linéaire.

5. Adhésif thermosoudable conformément à au moins une des revendications 1 à 4,
caractérisé par
l'indice d'OH du polyol de 1 à 200 et un poids moléculaire moyen de 500 à 100 000.

6. Adhésif thermosoudable selon au moins une des revendications 1 à 5,
caractérisé par
des polymères d'ester d'acryle ayant une somme d'indices d'acidité et d'indice d'OH, de 1 à 200.

7. Adhésif thermosoudable selon au moins une des revendications 1 à 6,
caractérisé par
le rapport en poids du polymère d'ester d'acryle au produit d'addition résine époxy/novolaque allant de 0,1 à 100 à 100:10.

8. Adhésif thermosoudable selon au moins une des revendications 1 à 7,
caractérisé par
le rapport en poids des composants A) à B) ou C) allant de 1:50 à 50:1.

9. Utilisation des adhésifs thermosoudables selon au moins une des revendications 1 à 8 pour des articles électriques, en particulier pour l'isolation des conduites et des éléments de construction, pour la production de câbles plats et de revêtements de câble ainsi que comme matériau de base et feuille de recouvrement pour des circuits imprimés.
